# FASCICULE DE BREVET EUROPEEN

(11) **EP 2 568 492 B1**
(45) Date de publication et mention de la délivrance du brevet: **06.01.2016**
(21) Numéro de dépôt: 12176825.3
(22) Date de dépôt: 18.07.2012
(51) Int. Cl.: H01H 13/70, H03K 17/96

(54) **Pièce d'interface entre une carte électronique et son panneau de commande, interface mécanique formée d'une ou plusieurs des dites pièces et dispositif comprenant une telle interface mécanique**
Schnittstellenelement zwischen einer elektronischen Karte und ihrem Bedienungsfeld, aus einem oder mehreren solcher Elemente bestehende mechanische Schnittstelle und Vorrichtung, die eine solche mechanische Schnittstelle umfasst
Interface part between an electronic card and the control panel thereof, mechanical interface made up of one or more of said parts and device including such a mechanical interface

(30) Priorité: 07.09.2011 FR 1157962
(43) Date de publication de la demande: 13.03.2013
(73) Titulaire: Atlantic Industrie, 85000 La Roche sur Yon (FR)
(72) Inventeur: Goeury, Sébastien, 85600 Boufféré (FR); Cougnaud, Mathieu, 85000 LA ROCHE SUR YON (FR)
(74) Mandataire: Chaillot, Geneviève

(56) Documents cités:
- EP-A1- 1 732 224
- EP-A1- 2 166 670
- DE-A1-102006 039 133
- DE-A1-102009 021 033
- US-A- 5 892 652
- US-A1- 2008 099 322
- US-A1- 2008 190 751

## Description

L'invention concerne le domaine des systèmes électroniques comprenant une carte électronique commandable par un panneau de commande permettant de commander les paramètres de fonctionnement de ladite carte électronique par intervention physique de l'utilisateur. L'invention porte plus particulièrement sur une pièce d'interface entre une carte électronique (ou à circuits imprimés) et son panneau de commande, sur une interface mécanique conductrice constituée d'une ou plusieurs desdites pièces d'interface et sur un dispositif électronique comprenant une ou plusieurs interfaces mécaniques conductrices.

Un système électronique commandable par l'utilisateur comporte de manière générale une ou plusieurs cartes électroniques commandant le fonctionnement de ce système électronique. Pour une utilisation conviviale d'un système électronique commandable par l'utilisateur, la ou les cartes électroniques du système ne sont pas directement accessibles par l'utilisateur et sont protégées dans un boîtier. L'utilisateur interagit alors avec la ou les cartes électroniques du système électronique par l'intermédiaire d'un panneau de commande, souvent disposé en face avant dudit boîtier.

Il est alors nécessaire de détecter et de transmettre une information de commande de la carte électronique de l'utilisateur depuis ledit panneau de commande jusqu'à la carte électronique.

Il existe à l'heure actuelle plusieurs types d'interfaces entre un panneau de commande et une carte électronique.

Un premier type d'interface est le faisceau de fils conducteurs avec connecteur. Ce premier type d'interface est peu convivial pour l'utilisateur, et nécessite un nombre important de pièces et beaucoup de soudures, notamment entre les connecteurs et les fils et entre les fils et la carte électronique. Ce premier type est donc peu robuste et peu adapté à une fabrication en grande série, du fait du nombre de pièces et d'étapes d'assemblage.

Un deuxième type d'interface est constitué par les ressorts de type Philipp Spring®, placés entre une carte électronique et une touche de commande, et qui sont des ressorts comportant une première partie d'extrémité de fixation à la carte électronique, une partie cylindrique centrale et une deuxième partie d'extrémité conique s'évasant de la partie centrale vers l'extérieur, cette deuxième partie étant destinée, lorsque le ressort est comprimé avec cette deuxième partie comprimée, à former un disque de contact contre la touche pour détecter plus facilement une action sur la touche.

Ce deuxième type d'interface présente deux inconvénients. Premièrement, la sensibilité est faible car la zone active est un fil, et non une surface. Même lorsque la surface conique du ressort est comprimée, la surface en contact avec la touche est faible. De plus, ce type d'interface permet uniquement une détection de toucher, mais ne permet pas la détection d'une position d'un toucher.

Un troisième type d'interface est constitué par une pièce en forme de Z, faisant l'objet du dispositif à touche sensitive de la demande de brevet européen EP080865A1. Cette pièce en forme de Z et conductrice de l'électricité est placée entre la carte électronique et un panneau de commande de type verre ou vitrocéramique (électriquement isolant). Un toucher de l'utilisateur sur le panneau en vitrocéramique ou verre est détecté par effet capacitif sur la pièce en forme de Z, et transmis à la carte électronique par la pièce en forme de Z, la carte électronique comportant un circuit de détection de toucher relié à la pièce en forme de Z.

Ce troisième type d'interface, tout comme le deuxième type, ne permet que de détecter un toucher et non une position de toucher. De plus, du fait de la forme de la pièce en forme de Z avec une surface supérieure plane en contact avec le panneau de commande, il est nécessaire que la touche ou le panneau à travers lequel cette pièce en forme de Z est actionnée soit plan afin d'éviter toute non détection d'un toucher. En effet, la présence d'air entre la pièce en forme de Z et le panneau de commande diminue l'effet capacitif, et donc l'efficacité de détection de toucher.

Il existe également d'autres modes de transmission d'une instruction entre un panneau de commande et une carte électronique, de type transmission radio ou rupture de faisceau optique entre un émetteur et un récepteur, mais ces dispositifs sont coûteux et difficiles à mettre en oeuvre, notamment pour des dispositifs grand public.

Il est donc nécessaire de proposer une pièce d'interface conduisant à une interface mécanique conductrice ayant des procédés simplifiés de fabrication et de montage dans un dispositif électronique, avec un nombre minimal de soudures et de pièces nécessaires.

Il existe également un besoin pour une interface mécanique conductrice compacte, permettant de récupérer la distance entre le panneau de commande et la carte électronique, avec une bonne propriété de transmission électrique.

Enfin, il existe un besoin de simplification de l'interface mécanique conductrice par l'utilisation de l'électronique pour ne plus avoir de pièces mécaniques en mouvement.

La demande de brevet américain US 2008/190751 A1 décrit une pièce d'interface monobloc dont la partie supérieure est courbée, à courbure tournée vers le panneau de commande.

La demande de brevet européen EP 1732224 A1 décrit une pièce d'interface constituée par une lame métallique souple.

L'interface mécanique conductrice de l'invention est apte à absorber les tolérances mécaniques des différents assemblages (boîtier électronique/carte électronique/panneau de commande), et permet une localisation de l'appui/du toucher de l'utilisateur sur le panneau de commande.

De plus, la zone active de contact avec le panneau de commande est une surface, de telle sorte que la sensibilité de détection de toucher est importante.

L'invention vise donc à proposer une interface mécanique conductrice de structure simple, facile à fabriquer et à incorporer dans un système électronique commandable par un utilisateur, permettant à un utilisateur de commander une carte électronique d'un système électronique commandable depuis un panneau de commande. L'interface mécanique conductrice de l'invention permet de détecter une information de l'utilisateur entrée par le panneau de commande et de la transmettre à la carte électronique de manière fiable.

L'invention porte sur une interface mécanique conductrice constituée de deux pièces conductrices identiques, montées entre une carte électronique et un panneau de commande (pouvant aussi être une touche), ayant une forme permettant d'absorber les tolérances mécaniques et de rendre minimale la perte d'espace. La présence de deux pièces permet de déterminer une position exacte du toucher de l'interface par l'utilisateur, ce qui permet d'apporter une information supplémentaire par rapport au simple toucher de l'état antérieur de la technique.

L'interface mécanique conductrice selon l'invention ne comporte aucune pièce mobile, et est constituée de deux pièces uniquement.

L'interface mécanique conductrice de l'invention peut être utilisée par tout concepteur d'interface homme-machine, quel que soit le domaine (électroménager, automobile, domotique...) comme par exemple dans un dispositif à touches capacitives.

Elle peut également être utilisée avec tout système de touche avec un principe de mesure lié à la variation de capacité ou un principe de mesure de champ magnétique et/ou électrique.

Elle peut enfin être utilisée avec tout principe de touches supprimant les mouvements mécaniques.

L'interface mécanique conductrice de l'invention présente en outre des avantages d'étanchéité de panneau de commande, de marquage et d'isolation.

La présente invention a donc pour objet une pièce d'interface monobloc entre un panneau électriquement isolant et une carte électronique, ladite pièce d'interface comprenant une embase de connexion sur la carte électronique et une partie supérieure reliée de manière flexible à l'embase, la partie supérieure étant destinée à entrer en contact sur une première face du panneau électriquement isolant avec une zone de détection de toucher du panneau électriquement isolant et l'embase permettant une connexion électrique de la pièce d'interface à la carte électronique portant un circuit de détection de toucher, la pièce d'interface étant constituée en un matériau conducteur de l'électricité, caractérisée par le fait que la partie supérieure de contact avec le panneau électriquement isolant est déformable, de forme convexe, à convexité tournée vers la première face du panneau électriquement isolant, et reliée à l'embase à chaque extrémité de l'arc formé par la partie supérieure par une patte de liaison flexible, permettant une déformation de la partie supérieure de la pièce d'interface en position de montage entre le panneau électriquement isolant et la carte électronique afin que la partie supérieure de la pièce d'interface soit plaquée contre la zone de détection de toucher du côté de la première face du panneau électriquement isolant et épouse la surface de celui-ci.

Ladite pièce d'interface permet donc, lorsqu'elle est en contact avec la première face du panneau électriquement isolant, de détecter par effet capacitif un toucher d'utilisateur sur la zone de détection de toucher sur la face opposée du panneau électriquement isolant.

La convexité de la partie supérieure a pour effet que cette partie supérieure prend une forme bombée d'arc.

La partie supérieure peut être, de préférence, allongée dans la direction s'étendant d'un bord à l'autre de l'arc formé par la partie supérieure.

Ainsi, la partie supérieure non plane de la pièce d'interface se déforme au contact du panneau électriquement isolant pour épouser la surface ce celui-ci en adoptant une forme sensiblement plane, de telle sorte que la surface de contact entre la partie supérieure de la pièce d'interface et le panneau isolant est rendue maximale.

La présence d'air entre la pièce d'interface et le panneau isolant est également ainsi rendue minimale, ce qui augmente l'efficacité de l'effet capacitif et la sensibilité de détection de toucher.

La pièce d'interface selon la présente invention est donc de structure simple, monobloc.

Selon une première caractéristique particulière de l'invention, la partie supérieure peut être effilée d'une extrémité à l'autre de l'arc formé par la partie supérieure, la surface de contact entre la pièce d'interface et le panneau électriquement isolant ayant de préférence sensiblement la forme d'un trapèze rectangle. La partie supérieure de la pièce d'interface possède ainsi deux bords d'extrémité de l'arc formé par la partie supérieure, avec l'un des bords plus court que l'autre, et deux bords d'extrémité dans la direction perpendiculaire à la direction d'un bord à l'autre de l'arc formé par la partie supérieure, un premier bord perpendiculaire aux deux bords d'extrémité de l'arc formé par la partie supérieure, et un second bord incliné pour définir la forme effilée de la partie supérieure.

Cette forme de la partie supérieure permet de détecter plus ou moins de charge sur la partie supérieure en fonction de la position de toucher de l'utilisateur sur cette partie supérieure, et donc de pouvoir déduire la position de toucher de l'utilisateur sur la partie supérieure.

Selon une autre caractéristique particulière de l'invention, l'embase de la pièce d'interface peut être constituée par une ou plusieurs plaques, chacune reliée par une patte de liaison à la partie supérieure, ladite ou lesdites plaques permettant de connecter électriquement par soudure l'embase sur la carte électronique.

Selon une autre caractéristique particulière de l'invention, le matériau conducteur de l'électricité constituant la pièce d'interface peut être un matériau métallique de type lame souple, en particulier du cuivre.

L'embase de la pièce d'interface peut porter un ou plusieurs ergots s'étendant depuis l'embase à l'opposé de la partie supérieure pour l'enfichage de la pièce d'interface sur la carte électronique.

La présente invention a également pour objet une interface mécanique conductrice entre un panneau électriquement isolant et une carte électronique, caractérisée par le fait qu'elle comprend deux pièces d'interface, chacune telle que décrite précédemment. Suivant une caractéristique particulière lorsque la partie supérieure de chaque pièce d'interface est effilée d'une extrémité à l'autre de l'arc formé par sa partie supérieure, les deux pièces d'interface peuvent être agencées de telle sorte que le bord de l'arc formé par la partie supérieure de plus faible largeur d'une première pièce d'interface est aligné avec le bord de l'arc formé par la partie supérieure de plus grande largeur de la deuxième pièce d'interface, le bord de l'arc formé par la partie supérieure de plus grande largeur de la première pièce d'interface étant également aligné avec le bord de l'arc formé par la partie supérieure de plus faible largeur de la deuxième pièce d'interface, avec un espace entre les deux pièces d'interface.

Les deux pièces peuvent être de préférence assemblées de telle sorte que les parties supérieures des deux pièces d'interface forment au sein de l'interface mécanique conductrice une surface dite active sur laquelle la surface de contact du doigt de l'utilisateur avec chacune des deux pièces varie en fonction de la position du doigt de l'utilisateur. Ceci permet de détecter la position du doigt de l'utilisateur sur la surface dite active.

L'interface mécanique conductrice de l'invention est ainsi de structure simple, et nécessite peu de pièces et peu d'étapes d'assemblage.

Les première et deuxième pièces d'interface peuvent être assemblées de manière rigide par un élément de liaison isolant.

Ceci permet de diminuer le nombre d'étapes d'assemblage de l'interface mécanique conductrice sur une carte électronique.

L'élément isolant permet d'éviter l'échange de charges entre les deux pièces d'interface constituant l'interface mécanique conductrice, dans le but de pouvoir détecter une position de toucher par analyse de la différence de charges électriques échangées avec chacune des pièces d'interface lors d'un toucher de l'utilisateur.

L'invention a également pour objet un dispositif électronique, comprenant un boîtier, une carte électronique à l'intérieur du boîtier et un panneau de commande de ladite carte électronique constitué par une plaque électriquement isolante et constituant au moins une partie d'une face du boîtier, la carte électronique comprenant un circuit de détection de toucher, caractérisé par le fait qu'il comprend une ou plusieurs interfaces mécaniques conductrices telles que décrites ci-dessus, entre le panneau électriquement isolant et la carte électronique et connectées sur la carte électronique de façon à être en liaison avec le circuit de détection de toucher, chaque interface mécanique conductrice constituant une touche de commande des paramètres de fonctionnement de la carte électronique.

Chaque interface mécanique conductrice peut être soudée sur la carte électronique.

Lorsque chaque interface mécanique conductrice est constituée de pièces d'interface ayant des ergots sur leurs embases comme décrit ci-dessus, la carte électronique peut comporter des trous dans lesquels sont enfichés les ergots portés par chaque interface mécanique conductrice, chaque interface mécanique conductrice étant en outre facultativement soudée sur la carte électronique.

D'autres objectifs, avantages et caractéristiques nouvelles de la présente invention ressortiront davantage à la lecture de la description détaillée suivante, prise conjointement avec les dessins annexés.

Sur ces dessins :
- la Figure 1 est une vue en perspective d'une pièce d'interface selon un premier mode de réalisation l'invention ;
- la Figure 2 est une vue de côté de la pièce d'interface de la Figure 1 ;
- la Figure 3 est une vue en perspective d'une interface mécanique conductrice constituée de deux pièces d'interface selon la Figure 1 ;
- la Figure 4 est une vue schématique d'un dispositif électronique dans lequel est incorporée une interface mécanique conductrice selon la Figure 3 ; et
- la Figure 5 est une vue analogue à la Figure 4, dans laquelle l'interface mécanique conductrice est constituée de deux pièces d'interface selon un deuxième mode de réalisation de l'invention.

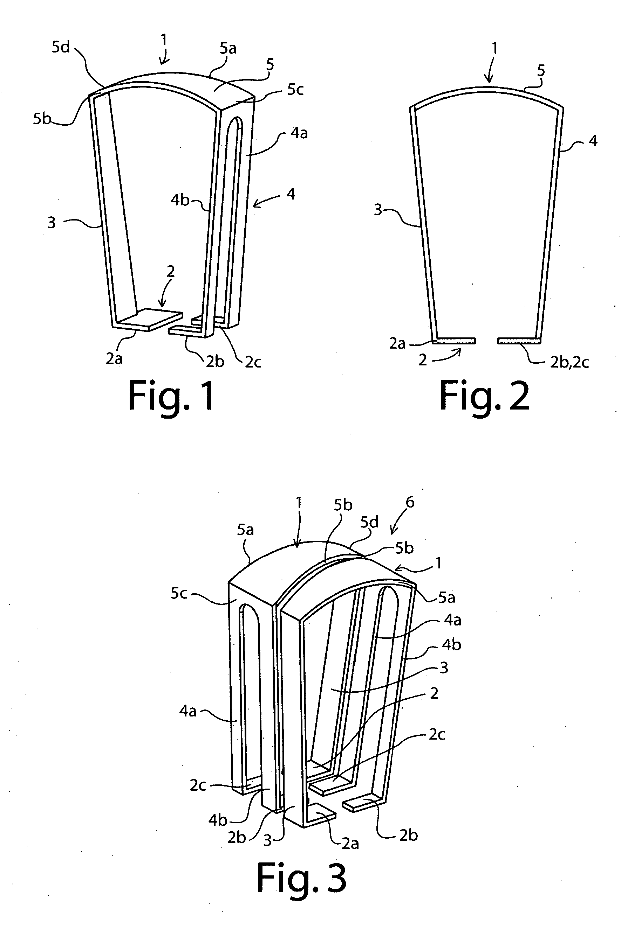

Si l'on se réfère aux Figures 1 et 2, on peut voir qu'il y est représenté une pièce d'interface 1 selon un premier mode de réalisation de l'invention.

La pièce d'interface 1 comporte une embase 2, des pattes 3 et 4 s'étendant à partir des extrémités de l'embase 2 de manière évasée, d'un même côté de celle-ci, et une partie supérieure 5, reliant les sommets des pattes 3 et 4, la partie supérieure 5 étant de forme allongée et convexe, à convexité tournée à l'opposé de l'embase 2, de telle sorte que la partie supérieure 5 adopte une forme bombée, comme on peut le voir sur la Figure 2.

La patte 3 est d'un seul tenant, la patte 4 se divisant en deux branches 4a, 4b, de la partie supérieure 5 vers l'embase 2.

Cette configuration de la patte 4 permet d'obtenir une économie de matière pour la matière utilisée pour constituer la pièce d'interface 1, mais il pourrait être envisagé de faire une patte 4 d'un seul tenant, de manière analogue à la patte 3, sans s'écarter du cadre de la présente invention.

L'embase 2 est constituée de trois plaques 2a, 2b, 2c, de niveau, formant la base de la pièce d'interface 1. La plaque 2a constitue le pied de la patte 3, les plaques 2b et 2c constituant les pieds respectifs des branches 4a et 4b de la patte 4. Les plaques 2a, 2b, 2c s'étendent à partir des extrémités inférieures des pattes respectivement 3 et 4, vers l'intérieur de la pièce d'interface 1, les plaques 2a, 2b, 2c n'étant pas en contact entre elles. On pourrait toutefois envisager une embase d'un seul tenant sans s'écarter du cadre de la présente invention.

Comme on peut le voir sur les Figures 1 et 3, la partie supérieure 5 de chaque pièce 1 comporte un bord longitudinal droit 5a et un bord longitudinal oblique 5b, la partie supérieure 5 s'effilant de son bord de liaison à la patte 4 à son bord de liaison à la patte 3, ayant donc un bord de liaison 5c à la patte 4 plus large que le bord de liaison 5d à la patte 3. La partie supérieure 5 adopte donc sensiblement une forme trapézoïdale rectangle, les bords de liaison 5c, 5d des pattes 3, 4 à la partie supérieure 5 constituant les bases dudit trapèze rectangle.

La pièce 1 est formée d'un seul tenant en une matière conductrice de l'électricité et déformable, à titre d'exemple une pièce avec une bonne conductivité volumique telle qu'un matériau métallique de type lame souple.

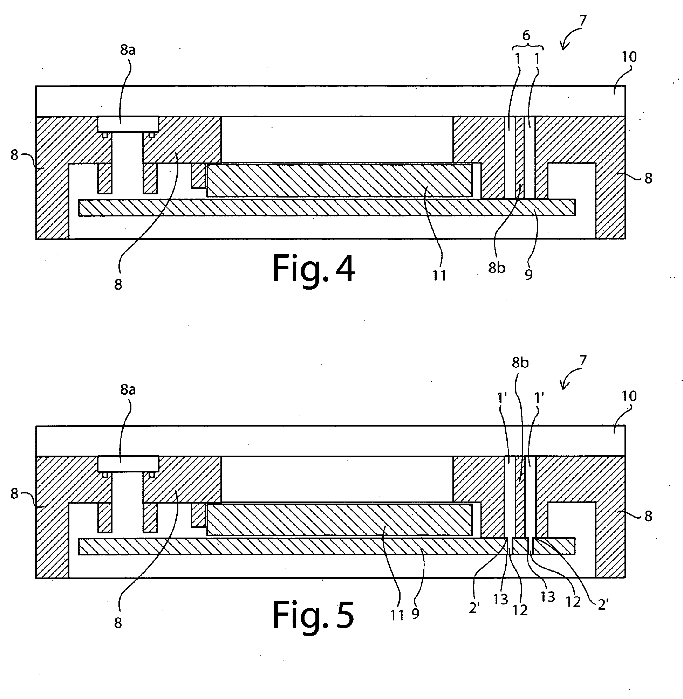

Dans le mode de réalisation de la pièce d'interface 1 représenté sur les Figures 1 à 3, la pièce d'interface 1 est fixée par soudure des plaques 2a, 2b, 2c sur une carte électronique (non représentée sur la Figure 3). Comme cela sera décrit en liaison avec la Figure 5 pour le deuxième mode de réalisation, l'interface mécanique conductrice peut également être implantée dans des trous formés dans la carte électronique, par l'intermédiaire d'ergots formés sur les plaques formant l'embase de chaque pièce d'interface, les ergots s'étendant à l'opposé de la partie supérieure de chaque pièce d'interface.

Comme on peut le voir sur la Figure 3, l'interface mécanique conductrice 6 selon un premier mode de réalisation de la présente invention est constituée d'une première pièce d'interface 1 et d'une deuxième pièce d'interface 1 selon les Figures 1 et 2, placées côte à côte de telle sorte que le bord 5b d'une première pièce d'interface 1 soit placé en regard du bord 5b de la deuxième pièce d'interface 1, avec un espace entre les deux pièces d'interface 1. Dans cette configuration, un premier plan contient la patte 3 de la première pièce d'interface 1 et la patte 4 de la seconde pièce d'interface 1, un autre plan contenant la patte 4 de la première pièce d'interface 1 et la patte 3 de la seconde pièce d'interface 1. Les bords longitudinaux 5a des première et deuxième pièces d'interface 1 constituant l'interface mécanique conductrice 6 sont donc parallèles.

Si l'on se réfère maintenant à la Figure 4, on peut voir qu'il y est représenté un dispositif électronique 7 comportant une interface mécanique conductrice 6 selon la présente invention.

Le dispositif électronique 7 comporte un boîtier 8, moulé en matière plastique, dans lequel est supportée une carte électronique 9, la face supérieure dudit dispositif électronique 7 étant constituée par un panneau de commande 10 en un matériau électriquement isolant, notamment de type verre ou matière plastique, fixé à la surface supérieure du boîtier 8. Le boîtier 8 comprend divers éléments, dont un élément de montage 8a du panneau de commande 10 et un élément de séparation 8b des deux pièces d'interface 1 constituant l'interface mécanique conductrice 6. L'élément de séparation 8b peut également être remplacé par du verre. Un écran à cristaux liquides 11 peut facultativement être placé dans le boîtier 8 sur la carte électronique 9 et connecté à celle-ci, afin d'afficher à l'utilisateur des données liées à la commande de la carte électronique 9 à travers le panneau de commande 10, qui dans le mode de réalisation représenté sur les Figures 4 et 5 est donc transparent.

L'interface mécanique conductrice 6 selon la présente invention est placée entre la carte électronique 9 et la face inférieure du panneau de commande 10, les embases 2 des pièces d'interface 1 constituant l'interface mécanique conductrice 6 étant soudées sur la carte électronique 9. L'interface mécanique conductrice 6 est connectée à un circuit de détection de toucher sur la carte électronique 9.

Les parties supérieures 5 des pièces d'interface 1 constituant l'interface mécanique conductrice 6 sont quant à elles en contact avec la face inférieure du panneau de commande 10, se déformant au contact de ladite face inférieure de panneau de commande 10 pour épouser la surface de la face inférieure du panneau de commande 10.

En effet, les pièces d'interface 1 constituant l'interface mécanique conductrice 6 selon l'invention étant faites à partir d'un matériau flexible/déformable, au contact de la face inférieure du panneau de commande 10, la partie supérieure 5 de chaque pièce d'interface 1 s'aplatit en écartant légèrement les sommets des pattes 3, 4 l'un de l'autre, ce qui permet à la partie supérieure 5 de chaque pièce d'interface 1 constituant l'interface mécanique conductrice 6 d'épouser parfaitement la surface de la face inférieure du panneau de commande 10 et donc de limiter la présence d'air entre l'interface mécanique conductrice 6 et la face inférieure du panneau de commande 10.

En utilisation, l'utilisateur touche la face supérieure du panneau de commande 10 au-dessus de l'interface mécanique conductrice 6. Des charges électriques sont alors échangées entre l'utilisateur et l'interface mécanique conductrice 6 à travers le panneau de commande 10 électriquement isolant par effet capacitif, lesquelles charges sont détectées par le circuit de détection de toucher sur la carte électronique 9 pour détecter un toucher (détection par effet capacitif).

La structure de l'interface mécanique conductrice 6, telle que représentée sur la Figure 3, constituée de deux pièces d'interface 1 séparées, permet de détecter une différence de charges électriques échangées entre l'utilisateur et chacune des pièces d'interface 1 constituant l'interface mécanique conductrice 6. Il est donc possible de détecter une position de toucher de l'utilisateur sur l'interface mécanique conductrice 6 par analyse des charges électriques échangées avec chacune des pièces d'interface 1 dans le circuit de détection de toucher, ce qui permet une plus grande fonctionnalité de la touche associée à l'interface mécanique conductrice 6.

Il est à noter que dans la vue schématique de la Figure 4, les pièces d'interface 1 constituant l'interface mécanique conductrice 6 sont séparées par un élément de la même matière que la matière constituant le boîtier 8 (matière plastique). Sans s'écarter du cadre de la présente invention, il est toutefois également envisageable que, comme représenté sur la Figure 3, les pièces d'interface 1 constituant l'interface mécanique conductrice 6 soient séparées uniquement par de l'air, et soudées sans autre séparateur sur la carte électronique 9.

Sur la Figure 5 est représenté un autre mode de réalisation de l'invention. Les éléments identiques à ceux décrits en liaison avec la Figure 4 portent les mêmes chiffres de référence, les éléments différents portant le même chiffre de référence que dans la Figure 4 avec le symbole « ' ».

Dans ce mode de réalisation, chaque pièce d'interface 1' comporte sur son embase 2' au moins un ergot 12, permettant d'implanter la pièce d'interface 1' dans des trous 13 formés dans la carte électronique 9. La liaison électrique des pièces d'interface 1' à la carte électronique 9 est assurée par soudure. Il est à noter que l'ergot peut également être monté à force sans soudure dans le trou de la carte électronique. Le montage à force assure dans ce cas une bonne connexion électrique entre la pièce d'interface et la carte électronique.

Cette configuration des pièces d'interface 1' constituant l'interface mécanique conductrice 6' permet une liaison plus robuste de l'interface mécanique conductrice 6' sur la carte électronique 9.

Afin de faciliter l'assemblage de l'interface mécanique conductrice selon l'invention sur la carte électronique, deux pièces d'interface constituant l'interface mécanique conductrice peuvent être préassemblées, liées par un élément électriquement isolant, afin de monter sur la carte électronique les deux pièces d'interface constituant l'interface mécanique conductrice en une seule étape.

Bien que le mode de réalisation préféré de la présente invention soit une interface mécanique conductrice constituée de deux pièces d'interface isolées afin de permettre une détection de la position de toucher d'un utilisateur sur l'interface mécanique conductrice comme indiqué précédemment, il est également possible d'envisager une interface mécanique conductrice constituée d'une seule pièce d'interface selon la présente invention, sans s'écarter du cadre de la présente invention.

## Revendications

1. Pièce d'interface (1, 1') monobloc entre un panneau électriquement isolant (10) et une carte électronique (9), ladite pièce d'interface (1, 1') comprenant une embase (2, 2') de connexion sur la carte électronique (9) et une partie supérieure (5) reliée de manière flexible à l'embase (2, 2'), la partie supérieure (5) étant destinée à entrer en contact sur une première face du panneau électriquement isolant (10) avec une zone de détection de toucher du panneau électriquement isolant (10) et l'embase (2, 2') permettant une connexion électrique de la pièce d'interface (1, 1') à la carte électronique (9) portant un circuit de détection de toucher, la pièce d'interface (1, 1') étant constituée en un matériau conducteur de l'électricité, la partie supérieure (5) de contact avec le panneau électriquement isolant (10) étant déformable, de forme convexe, à convexité tournée vers la première face du panneau électriquement isolant (10), et reliée à l'embase (2, 2') à chaque extrémité de l'arc formé par la partie supérieure (5) par une patte de liaison (3, 4) flexible (2, 2'), permettant une déformation de la partie supérieure (5) de la pièce d'interface (1, 1') en position de montage entre le panneau électriquement isolant (10) et la carte électronique (9) afin que la partie supérieure (5) de la pièce d'interface (1, 1') soit plaquée contre la zone de détection de toucher du côté de la première face du panneau électriquement isolant (10) et épouse la surface de celui-ci, **caractérisée par le fait que** la partie supérieure (5) est effilée d'une extrémité à l'autre de l'arc formé par la partie supérieure (5), la surface de contact entre la pièce d'interface (1, 1') et le panneau électriquement isolant (10) ayant sensiblement la forme d'un trapèze rectangle.

2. Pièce d'interface (1, 1') selon la revendication 1, **caractérisée par le fait que** l'embase (2, 2') de la pièce d'interface (1, 1') est constituée par une ou plusieurs plaques (2a, 2b , 2c), chacune reliée par une patte de liaison (3, 4, 4a, 4b) à la partie supérieure (5), ladite ou lesdites plaques (2a, 2b , 2c) permettant de connecter électriquement par soudure l'embase (2, 2') sur la carte électronique (9).

3. Pièce d'interface (1, 1') selon l'une des revendications 1 ou 2, **caractérisée par le fait que** le matériau conducteur de l'électricité constituant la pièce d'interface (1, 1') est un matériau métallique de type lame souple.

4. Pièce d'interface (1') selon l'une des revendications 1 à 3, **caractérisée par le fait que** l'embase (2') de la pièce d'interface (1') porte un ou plusieurs ergots (12) s'étendant depuis l'embase (2') à l'opposé de la partie supérieure (5) pour l'enfichage de la pièce d'interface (14) sur la carte électronique (9).

5. Interface mécanique conductrice (6) entre un panneau électriquement isolant (10) et une carte électronique (9), **caractérisée par le fait qu'**elle comprend deux pièces d'interface (1, 1') chacune selon l'une des revendications 1 à 4.

6. Interface mécanique conductrice (6) selon la revendication 5, la partie supérieure (5) de chaque pièce d'interface (1, 1') étant effilée d'une extrémité à l'autre de l'arc formé par sa partie supérieure (5), **caractérisée par le fait que** les deux pièces d'interface (1, 1') sont agencées de telle sorte que le bord (5d) de l'arc formé par la partie supérieure (5) de plus faible largeur d'une première pièce d'interface (1, 1') est aligné avec le bord (5c) de l'arc formé par la partie supérieure (5) de plus grande largeur de la deuxième pièce d'interface (1, 1'), le bord (5c) de l'arc formé par la partie supérieure (5) de plus grande largeur de la première pièce d'interface (1, 1') étant également aligné avec le bord (5d) de l'arc formé par la partie supérieure (5) de plus faible largeur de la deuxième pièce d'interface (1, 1'), avec un espace entre les deux pièces d'interface (1, 1').

7. Interface mécanique conductrice (6) selon l'une des revendication 5 et 6, **caractérisée par le fait que** les première et deuxième pièces d'interface (1, 1') sont assemblées de manière rigide par un élément de liaison isolant.

8. Dispositif électronique (7), comprenant un boîtier (8), une carte électronique (9) à l'intérieur du boîtier (8) et un panneau de commande (10) de ladite carte électronique (9) constitué par une plaque électriquement isolante et constituant au moins une partie d'une face du boîtier (8), la carte électronique (9) comprenant un circuit de détection de toucher, **caractérisé par le fait qu'**il comprend une ou plusieurs interfaces mécaniques conductrices (6) selon l'une des revendications 5 à 7, entre le panneau électriquement isolant (10) et la carte électronique (9) et connectées sur la carte électronique (9) de façon à être en liaison avec le circuit de détection de toucher, chaque interface mécanique conductrice (6) constituant une touche de commande des paramètres de fonctionnement de la carte électronique (9).

9. Dispositif électronique (7) selon la revendication 8, dans lequel chaque interface mécanique conductrice (6) est constituée de pièces d'interface (1) selon l'une des revendications 1 à 4, **caractérisé par le fait que** chaque interface mécanique conductrice (6) est soudée sur la carte électronique (9).

10. Dispositif électronique (7) selon la revendication 8, dans lequel chaque interface mécanique conductrice (6) est constituée de pièces d'interface (1') selon la revendication 5, **caractérisé par le fait que** la carte électronique (9) comporte des trous (13) dans lesquels sont enfichés les ergots (12) portés par chaque interface mécanique conductrice (6), chaque interface mécanique conductrice (6) étant en outre facultativement soudée sur la carte électronique (9).

## Patentansprüche

1. Einteiliges Schnittstellenelement (1, 1') zwischen einer elektrisch isolierenden Tafel (10) und einer Leiterplatte (9), wobei das Schnittstellenelement (1, 1') ein Unterteil (2, 2') zum Anschluss an die Leiterplatte (9) und einen oberen Abschnitt (5) umfasst, der flexibel mit dem Unterteil (2, 2') verbunden ist, wobei der obere Abschnitt (5) dafür bestimmt ist, an einer ersten Fläche der elektrisch isolierenden Tafel (10) einen Berührungserkennungsbereich der elektrisch isolierenden Tafel (10) zu berühren, und wobei das Unterteil (2, 2') eine elektrische Verbindung des Schnittstellenelements (1, 1') mit der Leiterplatte (9) ermöglicht, die eine Berührungserkennungsschaltung trägt, wobei das Schnittstellenelement (1, 1') aus einem elektrisch leitenden Material besteht, wobei der obere Abschnitt (5) für den Kontakt mit der elektrisch isolierenden Tafel (10) verformbar ist, konvex geformt ist, mit einer zur ersten Fläche der elektrisch isolierenden Tafel (10) gerichteten konvexen Form, und mit dem Unterteil (2, 2') an jedem Ende des Bogens, den der obere Abschnitt (5) bildet, über einen flexiblen (2, 2') Verbindungssteg (3, 4) verbunden ist, der eine Verformung des oberen Abschnitts (5) des Schnittstellenelements (1, 1') in der Einbaulage zwischen der elektrisch isolierenden Tafel (10) und der Leiterplatte (9) ermöglicht, damit der obere Abschnitt (5) des Schnittstellenelements (1, 1') gegen den Berührungserkennungsbereich auf der Seite der ersten Fläche der elektrisch isolierenden Tafel (10) gedrückt ist und sich an die Oberfläche derselben anpasst, **dadurch gekennzeichnet, dass** sich der obere Abschnitt (5) von einem Ende zum anderen des Bogens, den der obere Abschnitt (5) bildet, verjüngt, wobei die Kontaktfläche zwischen dem Schnittstellenelement (1, 1') und der elektrisch isolierenden Tafel (10) im Wesentlichen die Form von einem rechteckigen Trapez aufweist.

2. Schnittstellenelement (1, 1') nach Anspruch 1, **dadurch gekennzeichnet, dass** das Unterteil (2, 2') des Schnittstellenelements (1, 1') von einer oder mehreren Platten (2a, 2b, 2c) gebildet ist, die jeweils über einen Verbindungssteg (3, 4, 4a, 4b) mit dem oberen Abschnitt (5) verbunden sind, wobei die Platte oder Platten (2a, 2b, 2c) den elektrischen Anschluss des Unterteils (2, 2') an der Leiterplatte (9) mittels Löten ermöglicht bzw. ermöglichen.

3. Schnittstellenelement (1, 1') nach Anspruch 1 oder 2, **dadurch gekennzeichnet, dass** das elektrisch leitende Material, das das Schnittstellenelement (1, 1') bildet, ein metallischer Werkstoff vom Typ elastischer Streifen ist.

4. Schnittstellenelement (1') nach einem der Ansprüche 1 bis 3, **dadurch gekennzeichnet, dass** das Unterteil (2') des Schnittstellenelements (1') zwecks Aufstecken des Schnittstellenelements (14) auf die Leiterplatte (9) einen oder mehrere Ansätze (12) trägt, die von dem Unterteil (2') aus gegenüber dem oberen Abschnitt (5) verlaufen.

5. Leitfähige mechanische Schnittstelle (6) zwischen einer elektrisch isolierenden Tafel (10) und einer Leiterplatte (9), **dadurch gekennzeichnet, dass** sie zwei Schnittstellenelemente (1, 1') jeweils nach einem der Ansprüche 1 bis 4 umfasst.

6. Leitfähige mechanische Schnittstelle (6) nach Anspruch 5, wobei sich der obere Abschnitt (5) jedes Schnittstellenelements (1, 1') von einem Ende zum anderen des Bogens, den sein oberer Abschnitt (5) bildet, verjüngt, **dadurch gekennzeichnet, dass** die beiden Schnittstellenelemente (1, 1') derart angeordnet sind, dass der schmalere Rand (5d) des Bogens, den der obere Abschnitt (5) bildet, eines ersten Schnittstellenelements (1, 1') nach dem breiteren Rand (5c) des Bogens, den der obere Abschnitt (5) bildet, des zweiten Schnittstellenelements (1, 1') ausgerichtet ist, wobei der breitere Rand (5c) des Bogens, den der obere Abschnitt (5) bildet, des ersten Schnittstellenelements (1, 1') ebenfalls nach dem schmaleren Rand (5d) des Bogens, den der obere Abschnitt (5) bildet, des zweiten Schnittstellenelements (1, 1') ausgerichtet ist, mit einem Zwischenraum zwischen den beiden Schnittstellenelementen (1, 1').

7. Leitfähige mechanische Schnittstelle (6) nach Anspruch 5 oder 6, **dadurch gekennzeichnet, dass** das erste und zweite Schnittstellenelement (1, 1') über ein isolierendes Verbindungselement starr verbunden sind.

8. Elektronische Vorrichtung (7), die ein Gehäuse (8), eine Leiterplatte (9) im Inneren des Gehäuses (8) und ein Bedienungsfeld (10) für die Leiterplatte (9) umfasst, das von einer elektrisch isolierenden Platte gebildet ist und zumindest einen Abschnitt einer Seite des Gehäuses (8) bildet, wobei die Leiterplatte (9) eine Berührungserkennungsschaltung umfasst, **dadurch gekennzeichnet, dass** sie eine oder mehrere leitfähige mechanische Schnittstellen (6) nach einem der Ansprüche 5 bis 7 zwischen der elektrisch isolierenden Tafel (10) und der Leiterplatte (9) umfasst, die so an die Leiterplatte (9) angeschlossen sind, dass sie eine Verbindung zu der Berührungserkennungsschaltung aufweisen, wobei jede leitfähige mechanische Schnittstelle (6) eine Bedientaste für Funktionsparameter der Leiterplatte (9) darstellt.

9. Elektronische Vorrichtung (7) nach Anspruch 8, wobei jede leitfähige mechanische Schnittstelle (6) aus Schnittstellenelementen (1) nach einem der Ansprüche 1 bis 4 gebildet ist, **dadurch gekennzeichnet, dass** jede leitfähige mechanische Schnittstelle (6) an die Leiterplatte (9) angelötet ist.

10. Elektronische Vorrichtung (7) nach Anspruch 8, wobei jede leitfähige mechanische Schnittstelle (6) aus Schnittstellenelementen (1') nach Anspruch 5 gebildet ist, **dadurch gekennzeichnet, dass** die Leiterplatte (9) Löcher (13) aufweist, in die die Ansätze (12) gesteckt sind, die von jeder leitfähigen mechanischen Schnittstelle (6) getragen werden, wobei jede leitfähige mechanische Schnittstelle (6) ferner gegebenenfalls an die Leiterplatte (9) angelötet ist.

## Claims

1. Monobloc interface part (1, 1') between an electrically insulating panel (10) and an electronic board (9), said monobloc interface part (1, 1') comprising a base (2, 2') for connection on the electronic board (9) and an upper part (5) flexibly connected to the base (2, 2'), the upper part (5) being designed to enter into contact, on a first face of the electrically insulating panel (10), with a touch sensitive area of the electrically insulating panel (10) and the base (2, 2') allowing an electric connection of the interface part (1, 1') to the electronic board (9) carrying a touch sensitive circuit, the interface part (1, 1') consisting of an electrically conductive material, the upper part (5) of contact with the electrically insulating panel (10) being deformable, of convex shape, with a convexity oriented towards the first face of the electrically insulating panel (10), and connected to the base (2, 2') at each end of the arc formed by the upper part (5) by a flexible (2, 2') connecting tab (3,4), allowing a deformation of the upper part (5) of the interface part (1, 1') in assembly position between of the electrically insulating panel (10) and the electronic board (9), so that the upper part (5) of the interface part (1, 1') is abutted against the touch sensitive area on the side of the first face of the electrically insulating panel (10) and conforms to the surface thereof, **characterized in that** the upper part (5) is tapered from an end of the arc formed by the upper part (5) to the other, the contact surface between the interface part (1, 1') and the electrically insulating panel (10) having substantially the shape of right trapezoid.

2. Interface part (1, 1') as claimed in claim 1, **characterized in that** the base (2, 2') of the interface part (1, 1') is constituted of one or more plates (2a, 2b, 2c), each connected by a connecting tab (3, 4, 4a, 4b) to the upper part (5), said plate(s) (2a, 2b, 2c) allowing to electrically connect the base (2, 2') on the electronic board (9) by welding.

3. Interface part (1, 1') according to one of claims 1 or 2, **characterized in that** the electrically conductive material constituting the interface part (1, 1') is a metallic material of reed type.

4. Interface part (1') according to one of claims 1 to 3, **characterized in that** the base (2') of the interface part (1') carries one or more lugs (12) extending from the base (2') on the opposite side to the upper part (5) toward plug in the interface part (14) in the electronic board (9).

5. Conductive mechanical interface (6) between an electrically insulating panel (10) and an electronic board (9), **characterized in that** it comprises two interface parts (1, 1') each according to one of claims 1 to 4.

6. Conductive mechanical interface (6) as claimed in claim 5, the upper part (5) of each interface part (1, 1') being tapered from an end of the arc formed by its upper part (5) to the other, **characterized in that** the two interface parts (1, 1') are arranged so that the edge (5d) of the arc formed by the upper part (5) of smallest width of a first interface part (1, 1') is aligned with the edge (5c) of the arc formed by the upper part (5) of greatest width of the second interface part (1, 1'), the edge (5c) of the arc formed by the upper part (5) of greatest width of the first interface part (1, 1') being also aligned with the edge (5d) of the arc formed by the upper part (5) of smallest width of the second interface part (1, 1'), with a spacing between the two interface parts (1, 1').

7. Conductive mechanical interface (6) as claimed in one of claims 5 and 6, **characterized in that** the first and second interface parts (1, 1') are rigidly assembled by an insulating connecting member.

8. Electronic device (7), comprising a housing (8), an electronic board (9) within the housing (8) and a control panel (10) of said electronic board (9) constituted by an electrically insulating plate and constituting at least a part of a housing (8) face, the electronic board (9) comprising a touch sensitive circuit, **characterized in that** it comprises one or more conductive mechanical interfaces (6) according to one of claims 5 to 7, between the electrically insulating panel (10) and the electronic board (9) and connected on the electronic board (9) so that they are connected to the touch sensitive circuit, each conductive mechanical interface constituting an operating parameters control key of the electronic board (9).

9. Electronic device (7) as claimed in claim 8, wherein each conductive mechanical interfaces (6) is constituted by interface parts (1) according to one of claims 1 to 4, **characterized in that** each conductive mechanical interface (6) is welded on the electronic board (9).

10. Electronic device (7) as claimed in claim 8, **characterized in that** each conductive mechanical interface (6) is constituted by interface parts (1') according to 5, wherein the electronic board (9) comprises holes (13) in which are plugged in the lugs (12) carried by each conductive mechanical interface (6), each conductive mechanical interface (6) being further optionally welded on the electronic board (9).
